Europäisches Patentamt

European Patent Office

Office européen des brevets

(19)

(11) **EP 1 607 759 A1**

(12) **EUROPEAN PATENT APPLICATION**

| | |
|---|---|
| (43) Date of publication:<br>**21.12.2005 Bulletin 2005/51** | (51) Int Cl.⁷: **G01R 31/34**, G01P 3/489,<br>G01P 3/48 |

(21) Application number: **05011575.7**

(22) Date of filing: **30.05.2005**

| | |
|---|---|
| (84) Designated Contracting States:<br>**AT BE BG CH CY CZ DE DK EE ES FI FR GB GR HU IE IS IT LI LT LU MC NL PL PT RO SE SI SK TR**<br>Designated Extension States:<br>**AL BA HR LV MK YU** | (72) Inventors:<br> • **Pariani, Angelo**<br>  **28053 Castelletto Ticino (Novara) (IT)**<br> • **Confalonieri, Enrico**<br>  **20161 Milano (IT)** |
| (30) Priority: **14.06.2004 IT MI20041190** | (74) Representative: **Cicogna, Franco**<br>**Ufficio Internazionale Brevetti**<br>**Dott.Prof. Franco Cicogna**<br>**Via Visconti di Modrone, 14/A**<br>**20122 Milano (IT)** |
| (71) Applicant: **E.D.C. Electrical Dynamic Company S.r.l.**<br>**20161 Milano (IT)** | |

(54) **Apparatus for detecting the operating characteristics of electric motors**

(57)    The present invention relates to an apparatus for detecting the operating characteristics of an electric motor, for production testings, laboratory analyses and the like, including a digital encoder which can be coupled, through a mechanical system, to an electric motor to be controlled.

The encoder is operatively connected, through a level adapter, to a measurement circuit provided on an acquisition card, coupled to a central unit or computer and to power supply units which can be selectively coupled to the electric motor being tested.

FIG.1

**Description**

**BACKGROUND OF THE INVENTION**

The present invention relates to an apparatus for detecting and/or measuring the operating characteristics of electric motors in production testings, laboratory analyses and the like.

As is known, a very important problem is that of properly testing and controlling electric motors and rotary machines in general.

At present, for carrying out the required measurements on electric motors, both in production testings and laboratory analyses, it is necessary to use discrete measuring and testing apparata, involving a comparatively long measurement time, and which, moreover, are very expensive both from a construction and an operating standpoint.

**SUMMARY OF THE INVENTION**

Accordingly, the aim of the present invention is to overcome the above mentioned problems, by providing an apparatus for detecting the characteristics of electric motors, particularly in production testings, laboratory analyses and the like, which is so designed as to be very simple and operatively flexible, and which allows, in a same equipment, to perform a broad range of measurements, in a very short measurement time.

Within the scope of the above mentioned aim, a main object of the present invention is to provide such an apparatus which allows to carry out very accurate measurements in a very short time, and, in particular, with respect to the stationary rotary speed of middle and high speed electric motors, the stationary rotary speed of low and very low speed electric motors, as well as of the dynamic speed, during acceleration and deceleration transient periods of said electric motors.

Another object of the present invention is to provide such an apparatus allowing to easily perform analysis operations with respect to the electric motor speed and torque oscillations, through the overall round angle thereof, in a stationary mode of operation, of its orders, during the acceleration and deceleration transient periods, and of the deceleration friction and quality of the rotor of the motor being tested.

Yet another object of the present invention is to provide such an apparatus which is very reliable and safe in operation.

According to one aspect of the present invention, the above mentioned aim and objects, as well as yet other objects, which will become more apparent hereinafter, are achieved by an apparatus for detecting the operating characteristics of an electric motor, in production testings and laboratory analyses, characterized in that said apparatus comprises a digital encoder which can be coupled, through a mechanical coupling system, to an electric motor to be tested, said digital encoder being operatively connected, through a level adapter, to a measuring circuit provided on an acquisition card coupled to a central unit or computer, said acquisition card being interconnected with power supply units which can be selectively coupled to said electric motor.

**BRIEF DESCRIPTION OF THE DRAWINGS**

Further characteristics and advantages of the present invention will become more apparent hereinafter from the following detailed disclosure of a preferred, though not exclusive, embodiment of an apparatus for detecting the characteristics of an electric motor, for production testings, laboratory analyses and the like, which is illustrated, by way of an indicative, but not limitative, example in the accompanying drawings, where:

Figure 1 illustrates a block diagram of the apparatus according to the invention;
Figure 2 illustrates a further block diagram clearly showing a component of the measurement circuit;
Figure 3 illustrates a connection diagram for connecting supply units which can be selectively coupled to the electric motor being tested;
Figure 4 illustrates a time-angular space diagram;
Figure 5 illustrates an angular space-time diagram;
Figure 6 illustrates the torque-RPM curve, and the related efficiency;
Figure 7 illustrates the dynamic speed-angular position curve;
Figure 8 illustrates the dynamic torque-angular position curve;
Figure 9 illustrates the curve related to the time signal of a closed-slot type of rotor in a good condition;
Figure 10 illustrates the time signal of a closed-slot type of defective rotor;
Figure 11 illustrates a spectrum analysis of the signal of figure 9 related to a closed-slot rotor in a good condition; and
Figure 12 illustrates a spectrum analysis of the signal of figure 10 related to a closed-slot defective rotor.

## DESCRIPTION OF THE PREFERRED EMBODIMENTS

With reference to the above mentioned figures, the apparatus for detecting the characteristics of an electric motor, for production testings, laboratory analyses and the like, comprises an electric motor 10 be tested, having an electric motor shaft 11 which is coupled to a mechanical system 20.

Said mechanical system 20 allows to quickly connect the electric motor shaft 11 to the shaft 31 of the digital encoder 30.

The mechanical system 20, in particular, is fitted to the size of the shaft of the electric motor being tested.

The digital encoder 30 provides an electric signal 32 including a sequence of pulses having a HIGH and a LOW level.

For each full rotation of the shaft. The encoder provides a pulse number NP.

Typically, NP=3600 pulses for revolution would be sufficient for also performing dynamic measurements, in the most part of applications.

The signal 32 is applied to the block 150.

This block is adapted to operate both as a level adapter between the encoder and measurement circuit timer 110, and as a signal squaring unit.

The function of this block would be particularly useful in applications in which the encoder is arranged at a spacing of several meters from the measurement circuit.

The computer 200 comprises a software program for managing an acquisition card 100 which is conventionally included in said computer.

More specifically, the herein used acquisition card is the National Instruments Mod.6014 card.

The system can however be used with other acquisition cards as available form other suppliers.

The acquisition card 100 comprises the following acquisition card sections:

1. a clock generating unit and time measurement circuits for measuring the generated pulses (TIMER), 110;
    a digital an analogic signal acquisition unit 120;
    a digital an analogic signal generating unit 130;

The computer 200, being coupled to a monitor, display, printer and/or plotter, 210.

The computer 200, through said acquisition card 100 and interface unit 190 controls or manages the following elements:

1. the power supply unit 60 for power supplying D.C. voltage electric motors;
2. the power supply unit 70 for power supplying single-phase and three-phase A.C. voltage electric motors;
3. a programming unit 80 for programming the capacity of single-phase capacitor electric motors (Permanent Split Capacitor PSC motors);
4. a braking programming unit 90.

The measurement system for measuring the revolution speed is operatively very flexible and allows to carry out a quick and accurate measurement both in a stationary status condition and in a dynamic status condition.

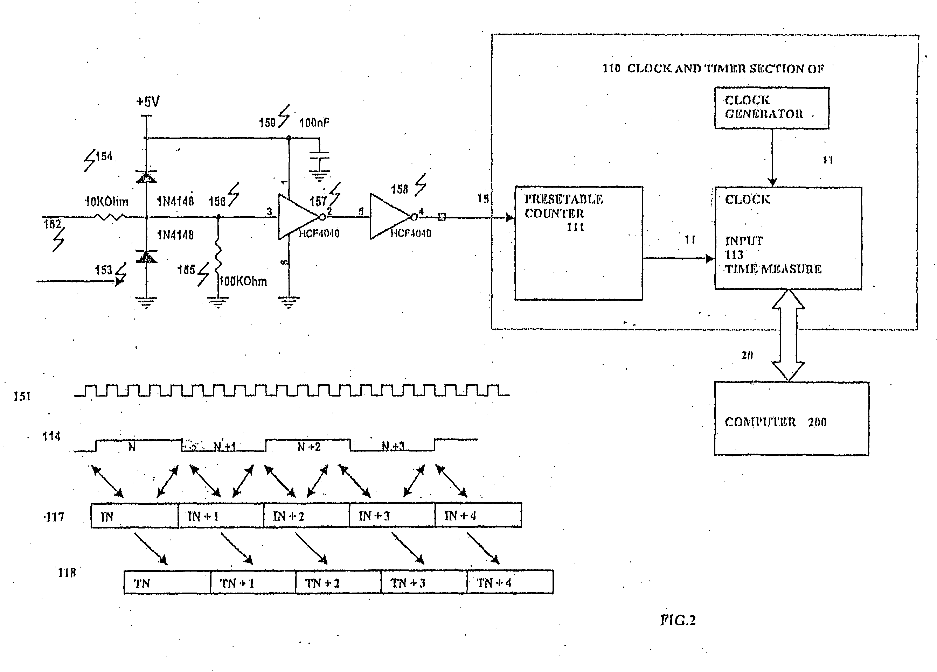

With reference to figure 2, the digital signal 32, provided by the digital encoder 30, is supplied to a comparing and level adapting circuit.

The signal 32, in particular, is applied through the resistor 152 having a value of 10Kohm, to two diodes 153 and 154 provided for clipping or limiting the signal amplitude.

A further resistor 155 being provided for reducing the circuit load impedance.

The signal 156 is applied to the input 3 of a section 157 of the integrated circuit HCF4049.

The output 2 of the section 156 is applied to the input 5 of a section 158 of the integrating circuit HCF4049.

The output 4, through the wire 151, is applied to the input of the unit 110 of the acquisition card 100.

The function of the two logic circuits 157 and 158 is that of speeding up the rising and falling edges of the signal.

This function is very important, in particular as the distance between the encoder 30 and digital measurement circuits 110 corresponds to several meters.

The signal 151 is in turn applied to the programmable divider 111.

The computer 200 is designed for programming any desired dividing or division factors N> = 2.

The split or divided signal 114 is supplied to the block Time Measurement element or block 113.

To this block is further applied a high frequency (> = 20MHz) clock signal 115, as generated by the clock circuit 112.

The circuit 113 transfers to a store area of the computer 200 a data array.

Each cell of this data array holds therein a number of the clock signal pulses 115 corresponding to the duration of each half-period of the signal 114.

Through a simple calculation, the number of pulses in each cell is transformed into the equivalent time: Tn = In * tc, where tc is equal to the period of the clock signal 115.

Depending on the application, a number NT of transitions to be stored will be programmed: typically NT = 1-10 for speed measurements in a stationary status and NT = 1,000-100,000 for speed measurements in a dynamic status or condition.

The stationary status rotary speed measurement case would correspond to conditions for which it is desired to calculate the rotary speed of the electric motor being tested, which would rotate at a nearly constant rotary speed.

In a case of high speed electric motors, for example having a rotary speed > = 300RPM, the system will be designed in the following manner:

1. Programming of NT = 1

2. Programming of the dividing factor N of the programmable divider 111 corresponding to an integer multiple NMED of the number of the pulses of the encoder 30 (NP). N = NMED*NP with NMED = 1,2,3,.... integer.

In this case, the time read-out in the single cell of the array 118 will correspond to: Tn = TR*NMED, where TR is the time necessary for a full revolution through the round angle.

Thus, it follows that: Tn = NMED *60 / RPM, where RPM is the revolution number per minute of the electric motor being tested.

The software program, with the time Tn being available, is adapted to evaluate the value of RPM = (NMED*60) /Tn.

For example, with NP = 3600; NMED = 5; NT = 1 if the value of RPM = 3000 then 0.1 second would be sufficient to evaluate such a rotary speed with an accuracy of +/- 1/(3600*5) = +/-1/180,000.

In a case of low speed electric motors, for example with a rotary of revolution speed < = 300RPM, the system will be designed as follows:

1. Programming of NT = 1

2. Programming of the dividing factor N of the programmable divider 111, corresponding to a fraction NMED of the number of the pulses of the encoder 30 (NP). N = NMED*NP with NMED < = 1.

Even in this case, the time read out in the single cell of the array 118 will correspond to: Tn = TR*NMED where TR is the time necessary to perform a full revolution through the round angle.

Thus, it will follow that: Tn = NMED *60 / RPM, where RPM is the number of revolutions per minute of the electric motor being tested.

The software program, as the tine Tn is available, will be able of evaluating the value of RPM.

For example, with NP = 3600; NMED = 0.05; NT = 1 if the RPM value is equal to 5, then 0.6 seconds would be sufficient to evaluate this revolution speed with an accuracy of +/-1/(3600*0.05) = +/-1/180.

This result would be a very good result, considering that the overall or total time to perform a full revolution of the electric motor would correspond to 12 seconds.

The case related to the measurement of the dynamic status rotary or revolution speed would correspond to condition for which it would be desired to achieve the acceleration or deceleration transient period of the motor being tested.

The computer 200 will program, through the sections 120 and 130 of the acquisition card 100, the blocks 60 or 70 depending on the supply voltage type to be used.

In particular, for a D.C. voltage electric motors; the block 60 will be programmed.

For A.C. single-phase or three-phase electric motors, the block 70 will be programmed.

In a case of a single-phase capacitor motor, the block 80 will be also programmed, so as to provide a suitable capacitor for the electric motor being tested.

The signals 62,72,82, respectively coming from the blocks 60, 70 and 80 are caused to pass through the switching block 40 and the block 50.

The latter, through the voltage and current measurement circuits, will provide these measurements on the wires 51.

This voltage and current signals, through the block INTERFACE BOARD, 190, and output wires 121, are supplied to the section 120 of the acquisition card 100.

In said section 120, the above mentioned signals will be processed to provide the instantaneous voltage, current and power information, during the acceleration transient period and the voltage information during the deceleration transient period, as the rotor quality detection is energized or actuated.

The main feature of the present invention is that the inventive speed or revolution measurement system can be designed through the SW program, without changing the hardware, to meet all the requirements, even of a very different type, which are involved in testing electric motors.

More specifically, for testing the characteristics of a motor, in particular in a production line, two parameters would be very important: the accuracy and time for achieving and processing the results.

The level comparing and adapting circuit 150 and the programmable divider 111 are essential for achieving the above mentioned two characteristics.

#### 4. Use of the dynamic speed measurement for detecting the torque - RPM curve

#### 4.1 Data acquisition

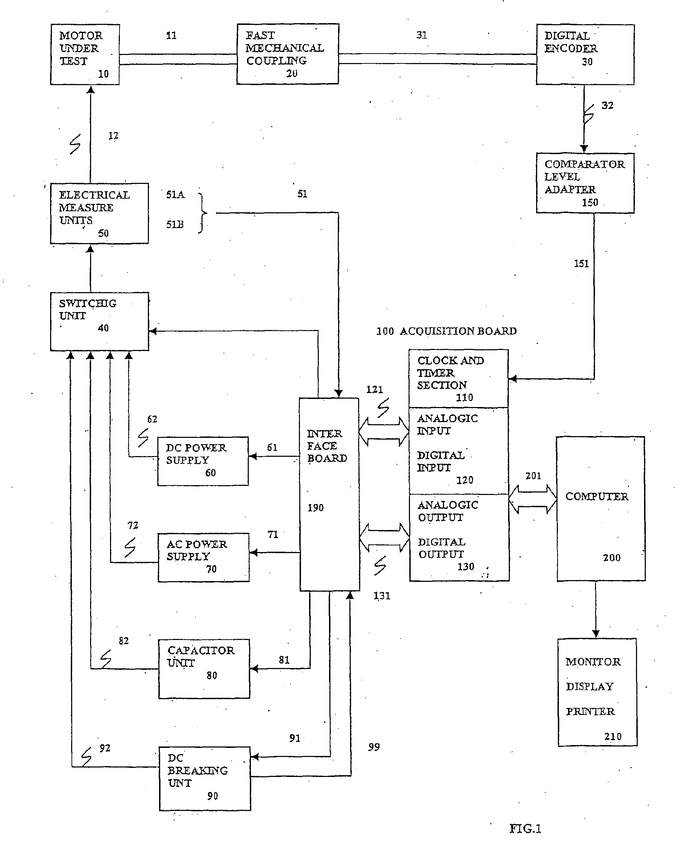

The pattern to be used is shown in figure 1. the electric motor 10 being tested is coupled to the motor coupling mechanical system 20, between the motor shaft 11 and encoder shaft 31.

Depending on the type of the motor being tested, the computer 200 will activate the motor being tested supply procedure, while programming the acquisition both of the signal 151 coming from the encoder and of the electric signals 51 coming the electric measurement unit 50 block.

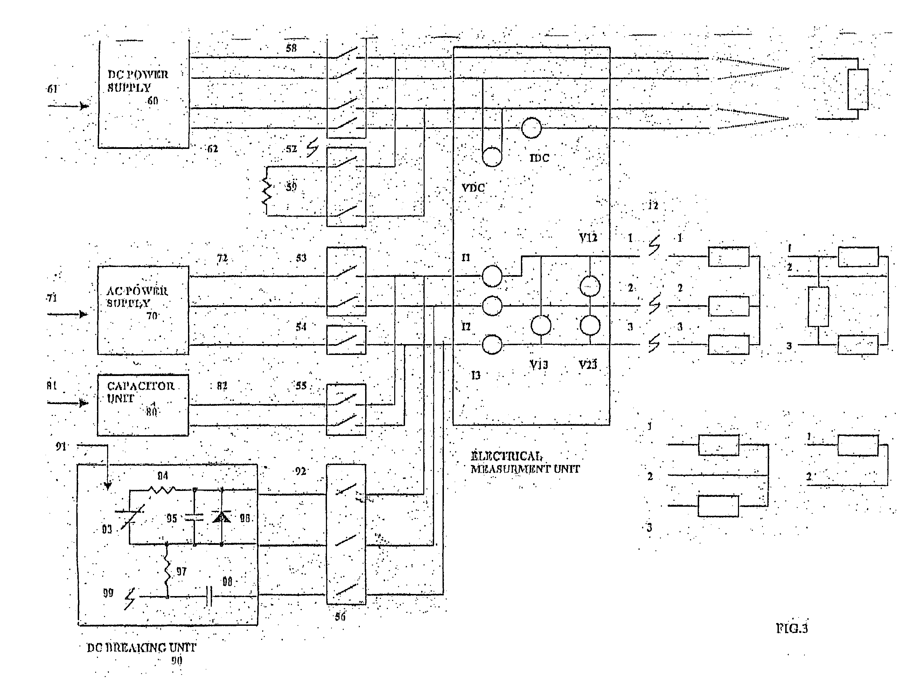

More specifically, with reference to figure 3:

1) in the case of the DC motors, the solid status switching system 52 will be actuated

2) in a case of a single-phase motor, the solid status switching system 53 will be actuated

3) in the case of a three-phase motor, the solid status switching system 53 and 54 will be actuated

4) in the case of a capacitor single-phase motor, at first in the unit 80 will be programmed, through the wires 81, the required capacity value, and then the solid status switching systems 55 and 53 will be actuated.

In this connection it should be pointed out that the switching systems 52, 53, 54, 55 and 56 are of a static type, and not of an electromechanic type, in order to prevent bouncing phenomena in the supply voltages (such as transient phenomena due to mechanical contact bounces).

In the case of a DC voltage motor, the voltage and current signals 51A will be acquired.

In the case of an AV voltage motor, the voltage and current signals 51B will be acquired.

Thus, the supplied motor will start to turn.

Simultaneously, the signal of the encoder 151 and the electric signals 51 associated with the acceleration transient period and the stationary status will be acquired.

After a programmable time, the deceleration step will be then started.

More specifically, the deceleration of the motor comprises two parts: the first, which is common to all types of motors, is that where the related solid status switching system (52 for DC voltage motors, 53 for single-phase motors, 53 and 54 for three-phase motors and finally 53, 55 for the single-phase capacitor controlled motors) is deactuated.

During this first decelerating step, and for a programmed type, the signal 151 coming from the encoder will be acquired.

The second operating step will determine the quick braking of the motor being tested thereby allowing, and limitedly to capacitor thee-phase and single-phase motors, to perform a so-called R-TEST measurement, for analyzing the rotor quality.

More specifically:

1) For a DC motor, the braking is performed by actuating the solid status switching system 58 which will actuate a programmable braking resistor 59. This resistor, which is connected to the winding ends, will provide a quick dissipation of the motor kinetic energy, thereby providing a quick braking.

2) For AC voltage motors, the actuation of the braking step or operation is performed as follows: the computer 200, through the drive or control wires 91, processes at first the value of the voltage generator (or current generator) 93. This value will control the motor braking time: the braking generator is connected on two phases of the power supply system through the resistor 94, the capacitor 95, the protective diode 96 and switching system 56.

3) For a single-phase motor, after having deactuated the solid status switching system 53, the solid status switching system 56 is energized for a programmed time so as to actuate the braking system.

4) For a three-phase motor, after having deactuated the solid status switching systems 53 and 54, the solid status switching system 56 is actuated for a programmed time so as to in turn actuate the braking system. During this braking step or operation, the voltage 99 to be used for the R-TEST measurement will be acquired.

5) For a single-phase capacitor motor, after having deactuated the solid status switching systems 53 and 55, the solid status switching system 56 will be actuated for a programmed time, thereby actuating the braking system. During the braking step, the voltage 99 necessary for performing the R-TEST measurement will be acquired.

Upon ending the above acquirement steps, the related data will be processed and displayed on the monitor or display 210. In a case of a production testing system, the above mentioned data will be compared with rated values, end then the monitor will display if the test has been either passed or not.

**4.1 Analysis of the data - determining the torque-RPM curve**

The acquirement and processing data are as follows:

1) NP = Number of pulses for revolution of the encoder 30
2) N = Dividing factor of the programmable divider 111
3) NMED = Full number of revolutions of the motor to be acquired during the acceleration step
4) NE = Number of the points to be processed
5) FT = Cut-off frequency of the low-pass filter
6) NV = Speed derivation interval (with possible only integer odd values > = 3)
7) NA = Acceleration derivation interval (with possible only integer odd values > = 3).

For determining the curve or relationship torque-RPM, the Newton $T(t) = M*d\omega/dt$ law is used, where $T(t)$ is the value of the instantaneous torque, M the sum of the moments of inertia of the motor rotor and coupling system and $d\omega/dt$ the instantaneous angular acceleration.

The calculation procedure provides the instantaneous speed and acceleration. By knowing the moment of inertia M, it is be possible to achieve the desired relationship. The following calculation steps will be performed:

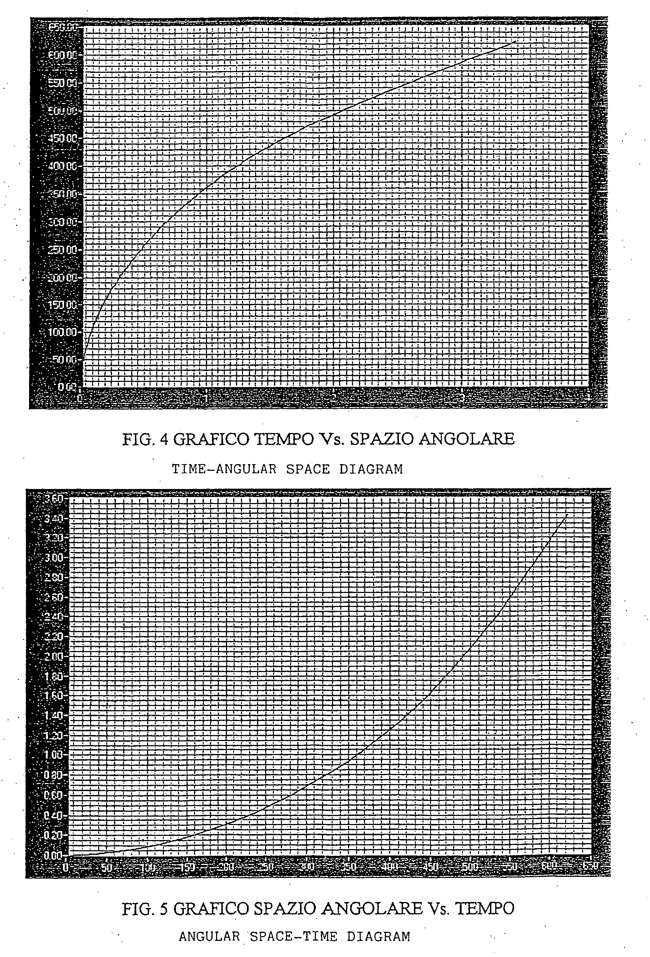

1) The acquirement of the pulses of the encoder 30 and processing of the section 110 will bring to the generation of the array 117 containing, in each cell thereof, the number of the clock signal pulses 115 corresponding to a half-period of the signal 114.
2) The array 118 holds in each cell thereof, the equivalent time value.
3) The array 140 holds the cumulative acceleration time. Each i-th cell holds: $Ti = Ti-1 + Ti$. The array 140 allows to provide the diagram Time = F(Space). See figure 4.
4) The acceleration limit time TL corresponding to the time for which the speed is held constant is obtained.
5) The preceding relationship is processed through an interpolation function, thereby generating a new array 141, having NE elements. Into each component of the array 141, the value calculated by the function Space = F(Time) is then introduced. The calculation of this function is carried out at even or regular intervals TE, where TE = TL/NE. This processing allows to achieve samples of the function Space = F/Time) which are equally time spaced.
6) The array 141 is subjected to a Fourier transform, thereby providing the array 142.
7) The samples of the array 142 are supplied to a low-pass filter having a cut-off frequency FT thereby providing the array 143.
8) The samples of the array 143 are subjected to a Fourier reverse transform, thereby returning to the time domain. Thus, the array 144 is generated. See figure 5.
9) The array 145 holds in each component thereof the instantaneous speed value. The i-th value is achieved by considering the slope of the segment obtained by a linear regression of NV points arranged about the i-th component of the array 144.
10) The array 146 holds in each component thereof the instantaneous acceleration value. The i-th value is obtained by considering the slope of the segment obtained by a linear regression of NA points arranged about the i-th component of the array 145.
11) The array 147 holds the value of the instantaneous torque (ACC(i)) associated with a given angular speed. The instantaneous torque value is achieved by multiplying each instantaneous acceleration value and the total moment of inertia M. Torque (i) = M*ACC(i).
12) The above mentioned arrays 145 and 147 allow to provide the torque - RPM curve after having suitably standardized the measurement units. Moreover, they allows to provide the array 148 holding the instantaneous value of the mechanical power made equal to P[W] = RPM * Torque [Nm]/10.

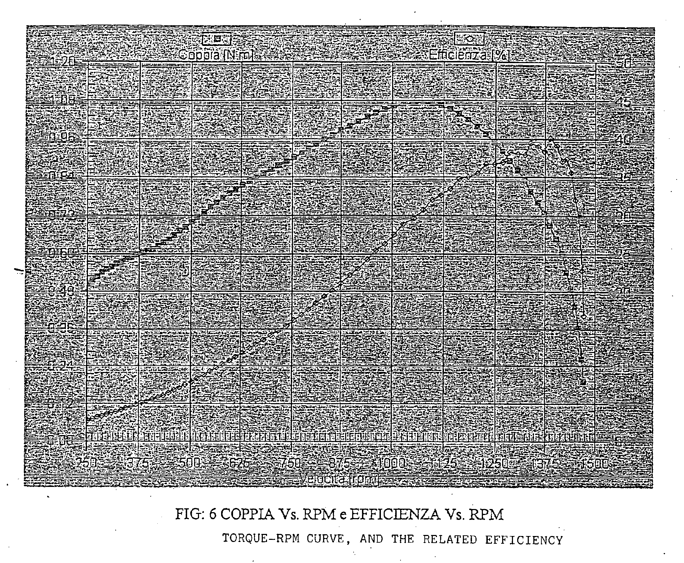

Figure 6 shows the torque-RPM curve related to the preceding diagrams.

**4.2 Analysis of the data and determining the Efficiency-RPM Curve**

As the acceleration transient period has a duration greater than 150-200msec, it is possible to actuate, simultaneously with the acquisition of the encoder signal, also the acquisition or acquirement of the voltage and current electric signals acquired by the block 50 and transmitted on the wires 51 to the interface board unit 190.

The unit 190 is provided with protective and level adapting circuits.

The signals 51 are caused to pass through these circuits, and accordingly are sent, at 121, to the section 120 of the acquisition card 100.

The above mentioned signals are sampled with a comparatively high frequency (20KHz for channel) and then they are further processed.

More specifically, the system is adapted, for each i-th component of the instantaneous speed array 145, to associate the i-th components of the arrays 150 to 161 holding the calculations of the instantaneous electric drains.

In particular, for DC voltage electric motors:

1) DC voltage array, 150;
2) DC current array, 151;

For single-phase electric motors, either with or without capacitor:

1) Voltage V array, 152;
2) Current I array, 153;
3) Active power W array, 154;
For three-phase motors:
4) Voltage V1 array, 155;
5) Voltage V2 array, 156
6) Voltage V3 array, 157;
7) Current I1 array, 158;
8) Current I2 array, 159;
9) Current I3 array, 160;
10) Active power W array, 161.

The calculations are carried out by considering the samples related to a period of the network voltage and arranged about the time corresponding to the i-th sample of the speed array 145.

Of great interest is therein the calculation of the electric motor being tested efficiency which is obtained as follows:

$$\text{Efficiency [\%]} = 100*\text{Generated Power/Drained Active Power}$$

Figure 6 also illustrates the efficiency = F(RPM) curve

In the case of quick transient phenomena, it is possible to increase the accelerating time by increasing the moment of inertia of the coupling system or by decreasing the power supply voltage.

In general, there is an optimum relationship between torque-RPM curves acquired at different voltages.

By decreasing the voltage, the RPM value being the same, the torque tends to decrease.

It is possible to refer to the torque value related to the rated voltage:

$$\text{Torque (at rated voltage)} = \text{Torque (at reduced}$$

$$\text{voltage)} * KC$$

where KC = (Rated Voltage/Reduced Voltage) ^2

## 5. Use of the dynamic speed measurement for detecting mechanical defects and/or vibrations

As the motor has achieved a stationary status of operation, it is possible to use the speed dynamic measurement for verifying the constant values of the instantaneous speed and instantaneous torque with respect to the angular position.

If necessary, it is possible to reprogram the section clock-timer 110 for achieving the speed values with the desired resolution.

The acquirement and calculation procedures are very similar to those shown for providing the torque-RPM curve with the exception of minimizing the filtering procedures.

The acquirement and processing parameters will be:

1) NP = Number of pulses for revolution of the encoder 30

2) N = Dividing factor of the programmable divider 111. Normally N = 2

3) NMED = Full number of revolutions of the motor to be analyzed. Normally NMED is from 1 to 3.

4) NV = Speed derivation interval (integer odd values > = 3). Normally NV = 3.

5) NA = Acceleration derivation interval (integer odd values > = 3). Normally from NA = 3.

The below calculation procedure will be used for determining the speed and accordingly the instantaneous dynamic acceleration.

1) The acquirement of the pulses of the encoder 30 and the following processing of the section 110 will bring to the generation of the array 170 holding in each cell thereof the number of pulses of the signal of the clock 115 corresponding to a half-period of the signal 114.

2) The array 171 holds the absolute value of the angular position, expressed in degrees. The first cell will be equal to zero, the second will correspond to 1*DA, the third to 2*DA, and the i-th will correspond to i-1)*DA, where DA = (360° * N)/(2*NP).

3) The array 172 holds in each cell thereof the equivalent value of the time necessary to pass through a fraction of the round angle corresponding to DA [°].

4) The array 173 holds the cumulative rotary of revolution time. Each i-th cell holds: Ti = Ti-1 + Ti. In this connection it should be pointed out that each cell is related to the time corresponding to a set or given angular position. The increment, in the terms of an angular space between two cells, is of a constant value.

5) The array 174 holds for each component the value of the instantaneous speed. The i-th value is obtained by considering the space-time curved determined by the arrays 171 and 173. From this curve is selected a portion of NV points arranged about the i-th component corresponding to the angular position the instantaneous speed thereof must be calculated. The slope of the segment achieved by a linear regression of NV points arranged about the i-th component will determine the instantaneous speed value.

6) The array 175 holds in each component thereof the instantaneous acceleration value. The i-th value is achieved by considering the speed-time curve determined by the arrays 174 and 173. Of this curve a portion of NV points arranged about the i-th component corresponding to the angular position the instantaneous speed of which must be calculated is selected. The slope of the segment achieved by a linear regression of NA points arranged about the i-th component will determine the instantaneous speed value.

7) The array 176 holds the value of the instantaneous torque associated with a set angular position. The instantaneous torque value is obtained by multiplying each instantaneous acceleration value and the total moment of inertia M. Torque (i) = M*ACC(i).

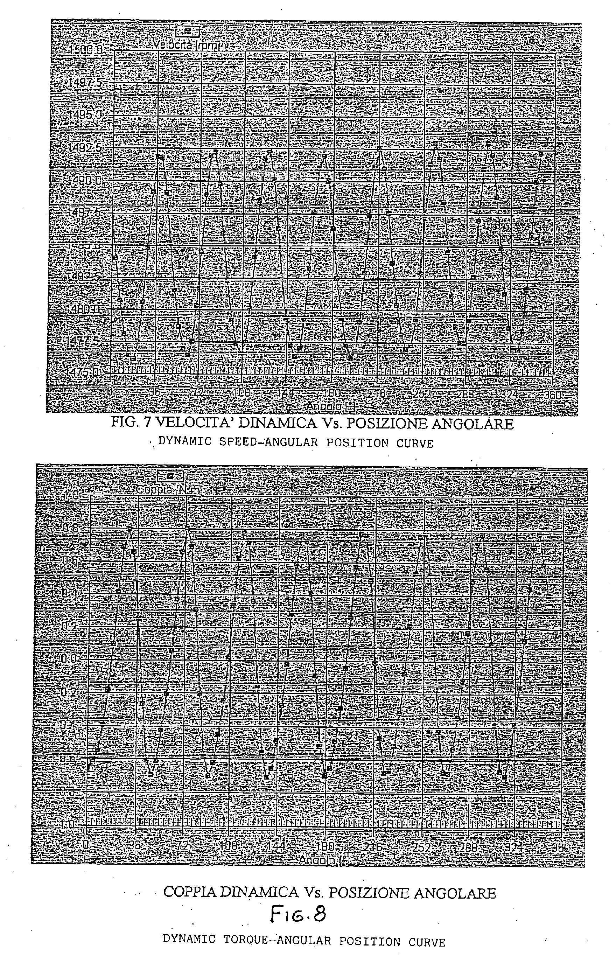

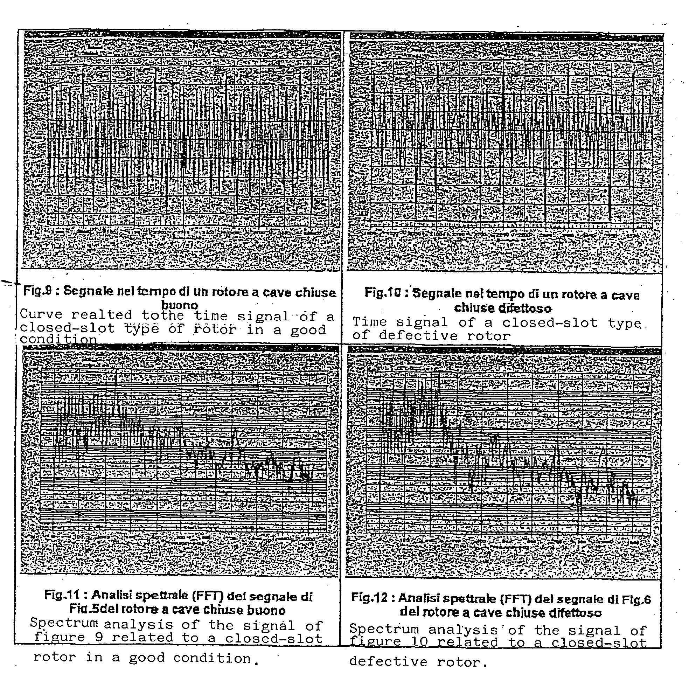

8) The arrays 174-171 and 175-171 allow, respectively, to provide the dynamic speed - angular position and dynamic torque - angular position curves after having performed a suitable standardization of the measurement units. See figure 7 and figure 8.

Such a measurement is very useful for production testing procedures.

In fact, by setting suitable limit accepting thresholds, it is possible to discard pieces which have peak values of the dynamic speed and/or torque larger than the corresponding values of proper pieces.

For lab applications, it is possible to apply the analysis of the orders on data of the array 147, holding the torque instantaneous values, by taking as a reference the data of the array 145 containing the instantaneous speed values.

## 6. Use of the dynamic speed measurement for detecting mechanical defects and/or frictions

After having completed the stationary step, the deceleration transient analysis step is started.

As above disclosed, depending on the type of the motor being tested, the power supply voltage is removed through the disclosed solid status switching systems.

Simultaneously, the acquirement of the signal of the encoder 30 is energized or actuated.

This processing is carried out for acquiring the time TM consumed by the motor for passing through a given number NMED of round angles.

In actual production systems one will have two accepting limits (TNmin and TMmax) for the related value TM.

The acquirement and processing parameters will be:

1) NP = Number of pulses for each revolution of the encoder 30

2) NMED = Number of revolutions of the electric motor for measuring the time TM

3) N = Division factor of the programmable divider 111 N = NP*NMED

The section TIMER 113 will give a single value XP through which it will be possible to calculate TM:

TM = XP*1/FC where FC is the frequency of the clock signal 115 (usually = 20MHz).

It should be pointed out that for lab applications it would be possible to perform the same analysis as that used during the acceleration transient to calculate the instantaneous speed and instantaneous acceleration as time functions.

The instantaneous acceleration - time curve can be represented as a friction torque Vs time by the relationship C(t) = M*ACC(t), where M is the momentum of inertia and ACC(t) is the acceleration at the time T.

### 7. Braking step

In production testing procedures, it would be suitable to speed up the conclusion of the test by introducing an electric braking of the motor.

For DC voltage electric motors, this is achieved by connecting a resistor 59 in parallel to the motor winding.

In single-phase electric motors this is achieved by applying a DC voltage 93 at the ends of the winding through the solid status switching circuit 56.

Such an operation is likewise performed for single-phase capacitor electric motors and for three-phase motors.

In the latter two cases, is also possible to exploit such a situation for performing a very interesting measurement allowing to test or check the quality of a die-cast rotor.

This test has been called by the Applicant "R-TEST (ROTOR TEST).

### 8. Checking the Rotor (R-TEST)

This test is applied to three-phase and single-phase electric motors including several windings (single-phase motors with starting and running windings), since it requires the provision of at least 2 windings. In actual practice, by applying the braking DC voltage/current 93 at the end of a winding (terminals 1-2, reference 12), there is achieved the voltage generated by the motor on the other winding (terminals 3-2, reference 12).

This voltage, through the capacitor 98 and load resistor 99, is transferred to the interface unit 190 and accordingly to the analogic signal acquirement section 120 of the acquirement card 100.

During the deceleration step, the DC voltage/current supplied by the generator 93 will generate a constant magnetic field.

Since the rotor performs a rotary movement, it will cut through the flow lines of this magnetic field, thereby inducing a voltage in the second winding.

The induced signal will be typically a pseudo-sinusoid of decreasing amplitude, since the rotor speed is decreasing, and with a frequency FN equal to the number of the rotor bars NBR multiplied with the rotary frequency FR in turn multiplied with the pole number of the motor and divided by 2 (FN[Hz]=FR[Hz]*NBR*Pole Number/2).

For perfect rotors, the above mentioned signal will be very near to a sinusoid with a very small distortion, see figure 9.

For a defective rotor (for example having an interrupted bar), on the contrary, the sinusoid corresponding to the defective bar will have a high distortion or, if the bar is completely interrupted, it will have a very reduced amplitude, see figure 10.

On the signal 99, acquired by the winding, different controlling operations will be performed. More specifically:

1) the difference DA between the amplitudes of two consecutive signal periods, both for positive half-waves and for negative half-waves of said signal is calculated. Of all the detected DA values, the highest will be stored. This value will be compared with a preset value DAmax.
2) a Fourier transform is performed. In the resultant spectrum the frequency component corresponding to FR is identified, and its RMS value Vrms is calculated. This value will be compared with two set limits Min and Max.
3) the RMS total voltage, VN, of a spectrum sector between two set frequencies F1 and F2 is then calculated. Then, the coefficient RQF (Rotor Quality Factor) = Vrms/VN is calculated. This RQF coefficient is compared with a programmed lower limit. The calculated RQF value will provide an indication of the contents of the harmonics or sub-harmonics related to defects of the rotor.

Figure 11 and figure 12 show the spectra of the signals shown in figure 9 and figure 10.

From the above disclosure it should be apparent that the invention fully achieves the intended aim and objects.

In particular, the invention provides a very operatively flexible apparatus allowing to detect the characteristics of an electric motor, both of a three-phase and a single-phase type, thereby allowing to properly perform both production testing operations and lab analyses or the like.

The invention, as disclosed, is susceptible to several modifications and variations, all of which will come within the scope of the invention.

Moreover, all the constructional details can be replaced by other technically equivalent elements.

In practicing the invention, the used materials, provided that they are compatible to the intended applications, and the contingent size and shapes, can be any, according to requirements.

**Claims**

1. An apparatus for detecting operating characteristics of an electric motor, in production testings and laboratory analyses, **characterized in that** said apparatus comprises a digital encoder which can be coupled, through a mechanical coupling system, to an electric motor to be tested, said digital encoder being operatively connected, through a level adapter, to a measuring circuit provided on an acquisition card coupled to a central unit or computer, said acquisition card being interconnected with power supply units which can be selectively coupled to said electric motor.

2. An apparatus according to the preceding claim, **characterized in that** said card comprises a clock generating unit and time and pulse measurement circuits.

3. An apparatus according to claims 1 and 2, **characterized in that** said card comprises an acquirement unit for acquiring digital and analogic signals.

4. An apparatus according to one or more of the preceding claims, **characterized in that** said card comprises generating units for generating digital and analogic signals.

5. An apparatus according to one or more of the preceding claims, **characterized in that** said central unit is coupled to a monitor, a display, a printer and/or a plotter.

6. An apparatus according to one or more of the preceding claims, **characterized in that** said apparatus comprises moreover an interface unit for intercoupling said card and said supply units.

7. An apparatus according to one or more of the preceding claims, **characterized in that** said supply unit comprises a supply unit for DC voltage electric motors, a supply unit for AC single-phase and three-phase electric motors, a programming unit for programming capacitor values for single-phase capacitor electric motors, and a further programming and braking unit.

8. An apparatus according to one or more of the preceding claims, **characterized in that** said level adapter is a signal squaring adapter.

9. An apparatus according to one or more of the preceding claims, **characterized in that** said apparatus further comprises a speed measurement system including a programmable divider and being controlled by a dedicated program without changing hardware components.

10. An apparatus according to one or more of the preceding claims, **characterized in that** said apparatus comprises moreover coupling means for coupling a shaft of a motor being tested to a mechanical system designed for coupling said motor shaft to a corresponding shaft of said digital encoder.

11. An apparatus according to one or more of the preceding claims, **characterized in that** said digital encoder is coupled to an adapter block operating as a level adapter between said encoder and a measurement circuit and also operating as a signal squaring unit.

12. An apparatus according to one or more of the preceding claims, **characterized in that** said digital encoder supplies an output signal thereof to a level comparing and adapting circuit and, through a coupling resistor, to two signal amplitude limiting diodes.

13. An apparatus according to one or more of the preceding claims, **characterized in that** said apparatus comprises moreover resistor means for reducing the circuitry load impedance, and an integrated circuit HCF4049 for processing said signals.

**14.** An apparatus according to one or more of the preceding claims, **characterized in that** said integrated circuit HCF4049 is coupled to said card.

**15.** An apparatus according to one or more of the preceding claims, **characterized in that** said apparatus comprises moreover two logic circuits for speeding up the signal rising and falling edges, thereby allowing said encoder and digital measurement circuits to be arranged at a distance of several meters.

**16.** An apparatus according to one or more of the preceding claims, **characterized in that** said apparatus comprises moreover a programmable divider for processing said signals.

FIG.1

FIG.2

FIG.3

ELECTRICAL MEASURMENT UNIT

IDC

VDC

V12    V23

V13

I1    I2    I3

DC POWER SUPPLY 60

62

58

52

50

AC POWER SUPPLY 70

72

53    54    55

92

CAPACITOR UNIT 80

82

56

DC BREAKING UNIT 90

91    93    94    95    96    97    98    99

61    71    81

FIG. 4 GRAFICO TEMPO Vs. SPAZIO ANGOLARE

TIME-ANGULAR SPACE DIAGRAM

FIG. 5 GRAFICO SPAZIO ANGOLARE Vs. TEMPO

ANGULAR SPACE-TIME DIAGRAM

FIG: 6 COPPIA Vs. RPM e EFFICIENZA Vs. RPM

TORQUE-RPM CURVE, AND THE RELATED EFFICIENCY

FIG. 7 VELOCITA' DINAMICA Vs. POSIZIONE ANGOLARE

DYNAMIC SPEED-ANGULAR POSITION CURVE

COPPIA DINAMICA Vs. POSIZIONE ANGOLARE

FIG. 8

DYNAMIC TORQUE-ANGULAR POSITION CURVE

Fig.9 : Segnale nel tempo di un rotore a cave chiuse buono

Curve realted tothe time signal of a closed-slot type of rotor in a good condition

Fig.10 : Segnale nel tempo di un rotore a cave chiuse difettoso

Time signal of a closed-slot type of defective rotor

Fig.11 : Analisi spettrale (FFT) del segnale di Fig.5 del rotore a cave chiuse buono

Spectrum analysis of the signal of figure 9 related to a closed-slot rotor in a good condition.

Fig.12 : Analisi spettrale (FFT) del segnale di Fig.6 del rotore a cave chiuse difettoso

Spectrum analysis of the signal of figure 10 related to a closed-slot defective rotor.

## EUROPEAN SEARCH REPORT

**European Patent Office**

**Application Number**

EP 05 01 1575

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 6 591 200 B1 (COHEN MENACHEM ET AL) 8 July 2003 (2003-07-08) * abstract; claims 1-3,29,64; figures 2,3 * * column 1, line 27 - line 35 * * column 5, line 1 - line 24 * * column 5, line 44 - line 67 * * column 7, line 18 - line 38 * ----- | 1-16 | G01R31/34 G01P3/489 G01P3/48 |
| X | US 6 082 498 A (COSTE ET AL) 4 July 2000 (2000-07-04) * abstract * * column 3, line 9 - line 30 * ----- | 1-6,8-16 | |
| A | EP 0 735 664 A (SWITCHED RELUCTANCE DRIVES LTD; SWITCHED RELUCTANCE DRIVES LIMITED) 2 October 1996 (1996-10-02) * column 3, line 4 - line 16 * * column 7, line 10 - line 52; claim 2 * ----- | 9,16 | |
| A | US 6 051 987 A (STOKES ET AL) 18 April 2000 (2000-04-18) * column 2, line 36 - line 61 * * column 3, line 47 - line 61; figures 1,2 * ----- | 7 | **TECHNICAL FIELDS SEARCHED (Int.Cl.7)** G01R G01P |

The present search report has been drawn up for all claims

| Place of search | Date of completion of the search | Examiner |
|---|---|---|
| Berlin | 6 September 2005 | Binger, B |

## ANNEX TO THE EUROPEAN SEARCH REPORT
## ON EUROPEAN PATENT APPLICATION NO.

EP 05 01 1575

This annex lists the patent family members relating to the patent documents cited in  the above-mentioned European search report.
The members are as contained in the European Patent Office EDP file on
The European Patent Office is in no way liable for these particulars which are merely  given for the purpose of information.

06-09-2005

| Patent document cited in search report | | Publication date | Patent family member(s) | | Publication date |
|---|---|---|---|---|---|
| US 6591200 | B1 | 08-07-2003 | AT | 292804 T | 15-04-2005 |
| | | | AU | 748970 B2 | 13-06-2002 |
| | | | AU | 4056999 A | 05-01-2000 |
| | | | BR | 9911338 A | 13-03-2001 |
| | | | CA | 2334962 A1 | 23-12-1999 |
| | | | CN | 1497257 A | 19-05-2004 |
| | | | CN | 1310800 A ,C | 29-08-2001 |
| | | | DE | 69924609 D1 | 12-05-2005 |
| | | | EP | 1103815 A2 | 30-05-2001 |
| | | | EP | 1088237 A1 | 04-04-2001 |
| | | | HU | 0104326 A2 | 28-03-2002 |
| | | | WO | 9966335 A1 | 23-12-1999 |
| | | | JP | 2002518681 T | 25-06-2002 |
| | | | JP | 2001324395 A | 22-11-2001 |
| | | | MX | PA00012588 A | 08-05-2002 |
| | | | PL | 345001 A1 | 19-11-2001 |
| | | | RU | 2229135 C2 | 20-05-2004 |
| | | | TR | 200003747 T2 | 21-03-2001 |
| | | | TR | 200100035 T2 | 21-09-2001 |
| US 6082498 | A | 04-07-2000 | NONE | | |
| EP 0735664 | A | 02-10-1996 | AU | 717397 B2 | 23-03-2000 |
| | | | BR | 9601171 A | 06-01-1998 |
| | | | CA | 2172667 A1 | 29-09-1996 |
| | | | CN | 1153423 A ,C | 02-07-1997 |
| | | | DE | 69603644 D1 | 16-09-1999 |
| | | | DE | 69603644 T2 | 27-04-2000 |
| | | | EP | 0735664 A2 | 02-10-1996 |
| | | | JP | 3305947 B2 | 24-07-2002 |
| | | | JP | 9084375 A | 28-03-1997 |
| | | | SG | 63608 A1 | 30-03-1999 |
| | | | US | 5652494 A | 29-07-1997 |
| | | | ZA | 9602507 A | 29-09-1997 |
| US 6051987 | A | 18-04-2000 | NONE | | |

EPO FORM P0459

For more details about this annex : see Official Journal of the  European Patent Office, No. 12/82